Europäisches Patentamt

European Patent Office

Office européen des brevets

(11) Veröffentlichungsnummer: **0 002 725**
**B1**

(12) **EUROPÄISCHE PATENTSCHRIFT**

(45) Veröffentlichungstag der Patentschrift:
**30.05.84**

(51) Int. Cl.³: **C 09 D 3/49,** C 09 D 5/20,
C 08 L 71/02, H 05 K 3/28

(21) Anmeldenummer: **78101658.9**

(22) Anmeldetag: **13.12.78**

(54) **Filmbildende Zusammensetzung zur Beschichtung von Kontaktstiften eines Moduls.**

(30) Priorität: **23.12.77 US 864073**

(43) Veröffentlichungstag der Anmeldung:
**11.07.79 Patentblatt 79/14**

(45) Bekanntmachung des Hinweises auf die Patenterteilung:
**30.05.84 Patentblatt 84/22**

(84) Benannte Vertragsstaaten:
**DE FR GB**

(56) Entgegenhaltungen:
**US - A - 2 090 846**
**US - A - 2 399 085**
**US - A - 3 791 027**

(73) Patentinhaber: **International Business Machines Corporation, Old Orchard Road, Armonk, N.Y. 10504 (US)**

(72) Erfinder: **Bakos, Peter, 530 A Reuben Drive, Endicott, New York 13760 (US)**
Erfinder: **Haggett, Roger Eugene, 223 Ridgefield Road, Endicott, New York 13760 (US)**
Erfinder: **Poliak, Richard Martin, 3708 Rath Avenue, Endwell, New York 13760 (US)**

(74) Vertreter: **Kreidler, Eva-Maria, Dr. rer. nat., Schönaicher Strasse 220, D-7030 Böblingen (DE)**

ACTORUM AG

## Beschreibung

Die vorliegende Erfindung betrifft eine filmbildende Zusammensetzung zum Beschichten von Kontaktstiften eines Moduls vor dessen Rückseitenversiegelung. Die Zusammensetzungen der vorliegenden Erfindung, die filmbildend sind, können durch eine einfache Lösungsmittelbehandlung entfernt werden, nachdem sie dem gewünschten Zweck gedient haben. Die Zusammensetzungen der vorliegenden Erfindung zeigen auch Lötflussmitteleigenschaften.

Bei der Herstellung integrierter Schaltkreismoduln werden Einkapselungs- oder Einbettungsmaterialien wie eine Epoxidharzmischung verwendet, um die Rückseite des Moduls hermetisch abzudichten. Während der Aushärtung des Einbettungsmaterials wird ein unerwünschter Rückstand auf den Stiften für Eingangs- und Ausgangssignale des Moduls gebildet. Dieser Rückstand kann, wenn er nicht entsprechend entfernt wird, schlechte elektrische Leitfähigkeit bewirken, die die elektrischen Anschlüsse, beispielsweise in eine Schaltkarte, unzuverlässig machen. Ehe die vorliegende Erfindung gemacht wurde, war es notwendig, die Stifte abzuscheuern oder abzubrennen, um so viel wie möglich von dem Rückstand zu entfernen. Das Abscheuern kann jedoch die Stifte physikalisch beschädigen. Je dichter die Stifte auf einem Chip oder Modul zueinander angeordnet sind, um so schwieriger ist es, für das Scheuern zwischen dieselben zu gelangen. Andererseits ist auch das Brennen nicht vollständig befriedigend, weil dabei die Vorrichtung überschüssiger Hitze ausgesetzt wird, welche die Wirkungsweise der Vorrichtung nachteilig beeinflussen kann.

Aufgabe der Erfindung ist die Bereitstellung einer filmbildenden Zusammensetzung, mit der die bisher beschriebenen Nachteile vermieden werden können. Die Zusammensetzung soll leicht von dem elektrisch leitenden Substrat durch Waschen mit einem Lösungsmittel entfernbar sein. Ausserdem soll die gleichzeitig als Lötflussmittel wirken.

Die Aufgabe der Erfindung wird gelöst durch eine Zusammensetzung, wie sie in den Patentansprüchen gekennzeichnet ist. Sie ist dadurch gekennzeichnet, dass sie A) ein organisches Grundmaterial aus der Gruppe von Polyalkylenglykol, Polyalkylenglykolmonoester, Polyalkylenglykolmonoäther und Mischungen derselben, oder Kolophonium ins Schellack, B) ein Carbonsäureanhydrid einer Säure mit bis zu 18 C-Atomen, einen Aldehyd mit bis zu 18 C-Atomen, oder Mischungen derselben, C) eine kleine Menge eines filmbildenden, thermoplastischen Polymeren enthält, wobei die Bestandteile A) und B) ineinander löslich sind; Bestandteil C) mit Bestandteil A) mischbar ist, mit Bestandteil B) aber nicht reagieren darf. In einer vorteilhaften Ausgestaltung enthält sie zusätzlich ein nichtreaktives Verdünnungsmittel und einen Weichmacher.

Durch die erfindungsgemässe Zusammensetzung wird die Ausbildung von Rückständen, welche zäh an den Stiften haften, erheblich herabgesetzt, und ausserdem sind diese Rückstände viel leichter entfernbar. Die erfindungsgemässe Zusammensetzung gestattet eine Reinigung der Anschlussstifte durch einfaches Waschen nach der Rückseitenbeschichtung der Moduln. Bisher wurden Moduln auf einer gedruckten Schaltkarte mittels eines Lötprozesses befestigt. Dabei wurden Lötflussmittel auf die Anschlussstifte aufgetragen. Die Lötflussmittel dienen dazu, Oxide von den Anschlussstiften zu entfernen und eine Oxidation der Stifte zu verhindern, wenn diese erhöhten Temperaturen unterworfen werden, wodurch die elektrische Leitfähigkeit der Stifte erhalten bleibt. Es wurde nunmehr gefunden, dass die Zusammensetzungen der vorliegenden Erfindung, die eine Rückstandsbildung auf den Stiften während der Rückseitenbeschichtung verhindern, auch als Lötflussmittel wirken können.

Obwohl zahlreiche Lötflussmittel bekannt sind, ist bisher keine Zusammensetzung dieser Art bekannt, die gleichzeitig als Lötflussmittel wirkt und einen schützenden Überzug auf den leitenden Stiften bildet und dadurch die Bildung zäh anhaftender Rückstände während der Rückseitenbeschichtung der Moduln verhindert.

Obgleich die Verwendung bestimmter Anhydride in Lötflussmittelzusammensetzungen vorgeschlagen wurde, ist kein bestimmtes Lötflussmittel mit einem Gehalt an Anhydriden bekannt, welches eine filmbildende Zusammensetzung ist und die gewünschten Eigenschaften gemäss der Erfindung aufweist. Erwähnenswert in diesem Zusammenhang sind die US-Patentschriften 2473579 und 2672681, 3235414, 3264146, 3412133, 3791027 und 3970239.

In den US-Patentschriften 2672681, 3235414, 3264146 und 3970239 sind Lötflussmittel beschrieben, in denen verschiedene Anhydride der wichtigste Bestandteil des Lötflussmittels, welches zum Löten verwendet wird, sind. In diesen genannten Patentschriften ist jedoch die Verwendung von Anhydriden zusammen mit einem anderen Grundmaterial für Lötflussmittel nicht beschrieben. In der US-Patentschrift 3791027 sind verschiedene Typen von Lötflussmitteln beschrieben, von denen eines Bestandteile mit einer Carboxylfunktionalität enthält, welche gegen nachfolgende Polymerisation widerstandsfähig sind und nicht aushärten und deshalb leicht mit Lösungsmitteln entfernt werden können. Zusammensetzungen dieser Art können ein Anhydrid zusammen mit einem Lösungsmittel wie Diäthylenglykolmonoäthyläther enthalten (beispielsweise Spalte 3, Zeilen 39–52 und Spalte 4, Zeilen 6 bis 11 und 15). Bei den beschriebenen Materialien handelt es sich um andere als bei der vorliegenden Erfindung.

Auch in der US-Patentschrift 2473579 ist die Verwendung von Phthalsäureanhydrid als Schäummittel in einem Lötflussmittel beschrieben, welches bestimmte Chloride enthalten muss. Es findet sich in dieser Schrift jedoch kein Hinweis, dass diese speziellen Lötflussmittel filmbildende Eigenschaften in dem Masse aufweisen, dass sie die Stifte während der Rückseitenbeschichtung schützen können.

In der US-Patentschrift 3412113 ist die Verwendung bestimmter Anhydride organischer Phosphorsäuren beschrieben und angegeben, dass die Anhydride mit Metalloxyden reagieren und als Metallreinigungsmittel verwendet werden können. In der Patentschrift wird ferner vorgeschlagen, dass die Anhydride in Lötpasten und Flussmitteln verwendet werden können, weil sie zur Reinigung der Metalloberfläche dienen und eine saubere und feste Bindung der der Lötung gestatten (Spalte 3, Zeilen 29–33).

In den US-Patentschriften 2090846 und 3206324 wird die Verwendung von Aldehyden abgehandelt. In der US-Patentschrift 2090846 sind Zusammensetzungen beschrieben, welche höhere Säuren, Ester, Amide, Aldehyde, Ketone und Alkohole einschliessen. In dieser Patentschrift ist jedoch die gleichzeitige Verwendung eines Aldehyds mit einem anderen Lötflussmaterial, wie es gemäss der vorliegenden Erfindung gefordert wird, nicht beschrieben. Auch ist kein besonderer Vorteil bei der Verwendung eines Aldehyds anstelle einer Säure angegeben, die für die Zwecke der vorliegenden Erfindung nicht geeignet ist. Die spezielle einmalige Kombination von Eigenschaften, die durch die Zusammensetzung der vorliegenden Erfindung erhalten wird, ist in dieser Patentschrift nicht beschrieben. In der US-Patentschrift 3206324 ist die Verwendung von Aldehyden in Lötflussmitteln beschrieben zur Behandlung verschiedener Metalle, auf denen Nickel abgeschieden werden soll und in denen die Aldehyde dazu dienen, Metall aus den wässrigen Lösungen zu reduzieren. Der Zweck, zu dem die Aldehyde in dieser Patentschrift verwendet werden, ist ein ganz anderer als in der vorliegender Erfindung.

Die Verwendung verschiedener organischer Carbonsäuren als Zusätze zu Lötflussmitteln und ihre Wirkung als Aktivator ist ebenfalls bekannt. Säuren üben jedoch nicht die gleiche Funktion wie die Anhydride oder Aldehyde gemäss der vorliegenden Erfindung aus, weil filmbildenden Zusammensetzungen, die eine Bildung von Rückständen verhindern, nicht erhalten werden, wenn eine Säure angewendet wird. Von Interesse in diesem Zusammenhang sind die US-Patentschriften 3436278 und 3796610, 2898255 und 3205052.

In der US-Patentschrift 2399085 sind lösliche Zusammensetzungen beschrieben, die ein hochmolekulares Polyäthylenglykol enthalten. Die Löslichkeit dieser wachsartigen Materialien wird durch die Zugabe von Weinsäure und Alkalibicarbonat, das bei der Reaktion mit der Säure in Gegenwart von Wasser $CO_2$ entwickelt, bestimmt. Die Materialien finden Anwendung als zeitweiliges Siegel, als lösliches Pigmentbindemittel oder zur Herstellung von Formen für Spiralen, die nach dem Aufwickeln weggelöst werden. Dieser Patentschrift ist keinerlei Hinweis zu entnehmen, dass sich diese Materialien zur Beschichtung von Kontaktstiften eignen. Ausserdem wird die Löslichkeit des Polyäthylenglykols durch den Zusatz von Weinsäuren und Bicarbonat bestimmt.

Im Hinblick auf Lötflussmittel im allgemeinen sind die US-Patentschriften 2480723, 2482923 und 3075486 von Interesse. Sie stellen denjenigen Stand der Technik dar, in dem die Verwendung eines Weichmachers in Verbindung mit einem Lötflussmittel beschrieben ist. Die Verwendung eines Weichmachers in der vorliegenden Erfindung ist eine bevorzugte Ausführungsform.

Zusätzlich werden gemäss der vorliegenden Erfindung bestimmte Polymermaterialien zugesetzt, um die filmbildenden Eigenschaften der Zusammensetzung zu verbessern. Polymerzusätze sind beispielsweise in den US-Patentschriften 3837932 und 3791027 beschrieben. In der US-Patentschrift 3837932 ist eine Flussmittelzusammensetzung beschrieben, die aus einer wässrigen Suspension einer Polycarbonsäure und einem wasserlöslichen Polymermaterial, wie Polyvinylpyrrolidon, besteht. In der US-Patentschrift 3791027 ist eine Flussmittelzusammensetzung beschrieben, in der ein Maleinsäureanhydrid-Vinyläther-Copolymer (Gantrez der General Aniline and Film Corporation) als Flussmittel verwendet wird.

Das in der vorliegenden Patentanmeldung beschriebene System zur Beschichtung von Kontaktstiften auf Schaltkreismoduln, das gleichzeitig als Lötflussmittel wirkt und durch Waschen mit Wasser vollständig von der Unterlage entfernbar ist, ist in keiner der zuvor aufgeführten Patentschriften beschrieben oder durch diese nahegelegt. Zur Erfüllng der drei Kriterien war es erforderlich, ein spezielles Polymermaterial und ganz bestimmte Zusätze auszuwählen und zwar unabhängig davon, ob diese schon in anderen Lötflussmitteln mit anderen, spezifischen Eigenschaften zum Einsatz gekommen waren. Insbesondere wurde darauf abgestellt, dass das Material sich nicht nur als Lötflussmittel, sondern vor allem zur Beschichtung von Kontaktstiften eignet.

Die organischen Grundmaterialien, die erfindungsgemäss verwendet werden, sind bekannte Grundmaterialien, die in Lötflussmitteln verwendet werden. Sie sollen in dem Lösungsmittel, das zum Waschen der Stifte verwendet wird, löslich sein. Vorzugsweise sollte das Grundmaterial hinreichend wasser- oder alkohollöslich sein, so dass die endgültige filmbildende Zusammensetzung von den Stiften durch Waschen entweder mit Wasser oder Alkohol, beispielsweise Methanol oder Äthanol entfernt werden kann.

Die Alkylengruppen des bevorzugten Grundmaterials der Erfindung schliessen Äthylen, Propylen und Butylen oder Mischungen derselben ein, wobei Äthylen bevorzugt wird. Die bevorzugten Grundmaterialien gemäss der Erfindung haben Molekulargewichte von etwa 200 bis etwa 6000. Diese Materialien sind besonders für die Zwecke der vorliegenden Erfindung geeignet, weil sie eine hohe Temperaturstabilität, die erforderliche Viskosität und hohe Flammpunkte (über etwa 182° C) aufweisen. Einige im Handel erhältliche Grundmaterialien, die für die vorliegende Erfindung geeignet sind, schliessen Carbowax 300 in der Mono-

stearat-Form [HO(CH$_2$CH$_2$O)$_5$CH$_2$CH$_2$OOC(CH$_2$)$_{16}$CH$_3$]; Carbowax 400 in der Mono-laurat-Form [HO(CH$_2$CH$_2$O)$_8$CH$_2$CH$_2$OOC(CH$_2$)$_{10}$CH$_3$],. und Carbowax 400 in der Mono-oleat-Form [HO(CH$_2$CH$_2$O)$_8$CH$_2$CH$_2$OOC(CH$_2$)$_7$CH=CH(CH$_2$)$_7$CH$_3$] ein. Als Beispiel eines Polyoxyalkylenäthers wird ein Äther der unter der Bezeichnung P-15-200 in Handel von der Dow Chemical Company erhältlich ist, genannt. P-15-200 ist ein Polyoxyalkylenäther, der Methylseitenketten und endständige Hydroxylgruppen enthält. Die Zahl «200», die auf die «15» folgt, gibt die Viskosität des Materials in Centistokes bei 37,8° C an (200 cSt entspricht 200 mm$^2$/S).

Diese Materialien werden bevorzugt, weil Zusammensetzungen mit einem Gehalt an denselben schmelzen, wenn die beschichteten Stifte den erhöhten Temperaturen, die während der Anwendung des Lotes auftreten, ausgesetzt werden. Die Zusammensetzungen können daher auch als Flussmittel verwendet werden.

Andere geeignete Grundmaterialien sind Kolophonium oder Schellack, die beide alkohollöslich sind. Das Grundmaterial und das Anhydrid und/oder der Aldehyd müssen in einander in denjenigen Mengen, in denen sie in der Erfindung verwendet werden, löslich sein.

Nächstwichtigster Bestandteil der Zusammensetzung ist ein Carbonsäureanhydrid und/oder ein Aldehyd. Das Anhydrid kann ein Anhydrid einer Mono- oder Polycarbonsäure sein. Es kann ein gesättigtes, äthylenisch ungesättigtes, ein aliphatisches, cycloaliphatisches oder aromatisches Anhydrid sein. Beispiele einiger geeigneter Anhydride sind Essigsäureanhydrid, Propionsäureanhydrid, n-Buttersäureanhydrid, n-Valeriansäureanhydrid, Stearinsäureanhydrid, Bernsteinsäureanhydrid, Benzoesäureanhydrid, Phthalsäureanhydryd, Maleinsäureanhydrid, Methyl-bicyclo [2.2.1] hepten-2,3-dicarbonsäureanhydrid, Weinsäureanhydrid, Methylmaleinsäureanhydrid, Glutarsäureanhydrid, Polysebacinsäureanhydrid und Trimellithsäureanhydrid. Die Anhydride müssen in den in der erfindungsgemässen Zusammensetzung verwendeten Mengen in dem Grundmaterial löslich sein. Die Kombination von Grundmaterial und Anhydrid und/oder Aldehyd muss in der Waschflüssigkeit löslich sein. Wenn es gewünscht wird, können auch Mischungen von Anhydriden verwendet werden. Das zur Anwendung kommende Anhydrid ist ein Anhydrid einer Säure mit nicht mehr als 18 Kohlenstoffatomen.

Es wird angenommen, dass zwischen dem Anhydrid und dem Grundmaterial wie Polyäthylenglykol oder einem Derivat desselben eine Wechselwirkung stattfindet und dass das Anhydrid möglicherweise zu einer Vernetzung der einzelnen Moleküle beiträgt, um die filmbildende Charakteristik und die Eigenschaften der Zusammensetzung zu fördern. Andererseits wurde beobachtet, dass bei Verwendung einer Säure anstelle des korrespondierenden Anhydrids nicht die notwendige filmbildende Charakteristik gemäss der vorliegenden Erfindung erhalten wird.

Die Aldehyde, die im Rahmen der Erfindung bevorzugt werden, sind Verbindungen der allgemeinen Formel RCHO, in der R eine aliphatische Kohlenwasserstoffgruppe oder eine aromatische Gruppe, wie Benzol oder Naphtalin, oder ein substituiertes Benzol einschliesslich alkoxysubstituierter Ringe ist. Vorzugsweise sollen die Aldehyde in Wasser löslich sein. Die Aldehyde müssen in den angewendeten Mengen in dem Grundmaterial löslich sein. Aldehyde mit 5 oder mehr Kohlenstoffatomen sind nur wenig löslich in Wasser, werden aber von Alkoholen und Ketonlösungsmitteln leicht gelöst. Wenn dementsprechend solche Aldehyde verwendet werden, kann das Waschen unter Verwendung eines alkoholischen und/oder Acetonlösungsmittels durchgeführt werden. Beispiele geeigneter Aldehyde sind Acetaldehyd, Propionaldehyd, Butyraldehyd, Isobutyraldehyd, Benzaldehyd und Anisaldehyd. Wenn es gewünscht wird, können auch Mischungen von Aldehyden verwendet werden. Die Aldehyde, die eingesetzt werden, enthalten nicht mehr als 18 Kohlenstoffatome.

Um die Beschichtung der Stifte zu erleichtern und eine vollständige Bedeckung derselben zu erreichen, ist es erwünscht, die Viskosität der Zusammensetzung während der Beschichtung durch die Verwendung eines nichtreaktiven Verdünners zu reduzieren. Beispiele geeigneter Verdünner schliessen gesättigte aliphatische Alkohole, wie Methanol, Äthanol, n-Propanol, Isopropanol und n-Butylalkohol und verschiedene Glykolmonoalkyläther, wie Butylglykol, Äthylglykol, Methylglykol, n-Hexylglykol, Äthylglykolacetat und Dibutylglykol ein. Andere geeignete Lösungsmittel sind Ketone wie Aceton und Methyläthylketon. Wenn ein Verdünnungsmittel verwendet wird, wird es im allgemeinen in Mengen von etwa 50 bis 85,5 Gew.% und vorzugsweise in einer Menge von wenigstens 60 Gew.% verwendet.

Zusätzlich zu den zuvor angegebenen Bestandteilen wird eine kleine Menge eines synthetischen Polymere verwendet, um die filmbildende Charakteristik der Zusammensetzung zu verbessern. Das Polymere ist vorzugsweise wasserlöslich. Die verwendeten Polymeren müssen thermoplastische Polymere sein und dürfen mit dem Anhydrid und/oder Aldehyd der vorliegenden Zusammensetzung nicht reagieren. Darüber hinaus müssen die Polymeren mit dem Grundmaterial mischbar sein. Die bevorzugten Polymeren haben Molekulargewichte von 35 000 bis 150 000, und vorzugsweise von etwa 50 000 bis 100 000. Die bevorzugten Polymeren besitzen schwach basische Eigenschaften, d. h. sie bilden Salze mit wasserfreien Säuren. Beispiele geeigneter Polymerer sind Polyvinylpyrrolidon, Acrylatpolymere wie Polymethylmethacrylat, Maleinsäureanhydrid-Vinyläther-Polymere (z. B. Gantrez® der General Aniline and Film Corporation) und die Fluorpolymeren, die in der US-Patentschrift 3 734 791 beschrieben sind. Ein spezielles Fluorpolymer wird durch die Formel F(CF$_2$)$_7$CONHC$_3$H$_6$N(C$_2$H$_5$)$_2$CH$_3$I dargestellt. Es soll hervorgehoben werden, dass die Funktion der Fluorpolymeren nicht die gleiche ist wie die der anderen Polymeren, die erfindungsgemäss verwendet werden, beispielsweise wie die von Polyvinylpyrrolidon. So verbessert Polyvinylpyrrolidon z. B. die physikalischen Eigenschaften oder die filmbildende Charakteristik der Zusammensetzung. Wenn ein Polymermaterial angewendet wird, dann wird es im allgemeinen in einer Menge von etwa 0,2 bis 1 Gew.%, bezogen auf das Gesamtgewicht der Zusammensetzung, verwendet.

Um das beste Verhalten zu erreichen, sollte die Zusammensetzung der vorliegenden Erfindung auch einen Weichmacher enthalten. Dadurch wird gewährleistet, dass die Filme hinreichend flexibel sind und eine Rissbildung verhindert wird. Es werden verwendet Phthalate mit 14 bis 38 C-Atomen, Campher oder Triäthanolamin. In der Erfindung werden Phthalate bevorzugt, diese enthalten etwa 14 bis etwa 39 Kohlenstoffatome und haben Molekulargewichte von etwa 246 bis etwa 531. Beispiele geeigneter Phthalat-Weichmacher schliessen Diallylphthalat, Diallylisophthalat, Dibutylphthalat, Diamylphthalat, Diäthylphthalat, Dimethylphthalat, Dipropylphthalat und Ditridecylphthalat ein. Das am meisten bevorzugte Phthalat gemäss der vorliegenden Erfindung ist Diallylphthalat. Wenn ein Weichmacher verwendet wird, wird er in Mengen von 0,2 bis 1 Gew.% verwendet.

Die Zusammensetzungen gemäss der vorliegenden Erfindung können wahlweise auch bis zu 5 Gew.% einer Polycarbonsäure oder einer Mono- oder Polycarbonsäure mit einer Hydroxylgruppe enthalten. Die bevorzugten Carbonsäuren sind wasserlöslich und sollten mit dem Grundmaterial verträglich sein. Die Säuren begünstigen die Entfernung des Oxyds, wenn die Zusammensetzungen den Lötbedingungen unterworfen und werden daher wegen ihrer Flussmitteleigenschaften verwendet. Beispiele einiger geeigneter Polycarbonsäuren sind Oxalsäure, Malonsäure, Bernsteinsäure, Glutarsäure, Adipinsäure, Pimelinsäure, Suberinsäure und Maleinsäure. Es können gesättigte wie auch ungesättigte Säuren verwendet werden. Als Beispiele für Säuren, welche eine Hydroxylgruppe enthalten, werden Apfelsäure, Weinsäure und Zitronensäure genannt. Die (−)Form der Apfelsäure ist die Wasserlöslichere. der Apfelsäuren.

Der pH-Wert der Zusammensetzung liegt zwischen etwa 6 und 7, so dass die empfindlichen Komponenten des Moduls nicht beschädigt werden.

Es wurde gefunden, dass die Zusammensetzungen gemäss der Erfindung leicht hergestellt werden können, indem man zwei Vormischungen zubereitet und diese dann, wie nachfolgend angegeben, zusammenmischt:

| | | ungefähre Mengen in Gewichtsteilen |
|---|---|---|
| 1. Vormischung | Grundmaterial des Flussmittels | 5–30 |
| | | 40–50 |
| | Verdünner | 0,2–1 |
| | Weichmacher | |

| | | ungefähre Mengen in Gewichtsteilen |
|---|---|---|
| 2. Vormischung | Anhydrid und/oder Aldehyd | 10–30 |
| | | 20–40 |
| | Verdünner | 0,2–1 |
| | Polymer | |

Die Zusammensetzungen können auf die Metallstifte mittels bekannter Verfahren aufgetragen werden, beispielsweise durch Sprühen, Tauchen, Verspinnen oder Fliessbeschichten. Die Überzüge sollten auf die Oberfläche der Stifte nur in demjenigen Teil aufgetragen werden, der aus der Einkapselungszusammensetzung herausragt uns nicht in dem Bereich, der auch von der Einkapselungszusammensetzung bedeckt wird. Das Beschichten kann in vorteilhafter Weise bei Temperaturen von etwa Zimmertemperatur bis etwa 90°C durchgeführt werden. Ein geeigneter Weg zur Beschichtung der Stifte ist, einen Schwamm in der gewünschten Höhe zu tränken. Nachdem die Stifte beschichtet und von dem Schwamm weggenommen sind, wird der Modul umgekehrt, so dass er in der für die nachfolgende Rückseitenbeschichtung geeigneten Lage ist.

Da die Beschichtungszusammensetzung den Teil der Stifte, der durch die Einkapselungszusammensetzung bedeckt wird, nicht bedecken soll, ist es wesentlich, dass die Beschichtungszusammensetzung nicht an den Stiften herunterläuft in die Bereiche, die nachfolgend durch die Einkapselungs- oder Einbettungsmasse bedeckt werden. Der Bereich der Stifte, der durch die Einbettungs- oder Einkapselungsmasse bedeckt wird, wird im allgemeinen als der freizuhaltende Bereich der Stifte bezeichnet. Da keine der bisher bekannten Zusammensetzungen verwendet wird, um eine Abscheidung von Rückständen während der Rückseitenbeschichtung zu verhindern, wurde bisher auch nicht vorgeschlagen, die Zusammensetzung auf die Stifte vor der Rückseitenbeschichtung aufzutragen. Alle bisher bekannten Flussmittelzusammensetzungen wurden aufgetragen, nachdem die Rückseitenversiegelung stattgefunden hat. Wie zuvor bereits angegeben, ist es wesentlich, dass die Zusammensetzung nicht fliesst, sondern an den Stiften haftet. Nur eine Zusammensetzung mit diesen Eigenschaften kann vor der Rückseitenversiegelung angewendet werden.

Nach der Beschichtung der Stifte wird ein Einbettungs- oder Einkapselungsmaterial auf den Modul bis zur Höhe der freizuhaltenden Bereiche aufgetragen, um die elektrisch aktiven Bereiche des Moduls zu schützen und zu versiegeln. Hierzu geeignete Zusammensetzungen sind bekannt und brauchen deshalb nicht in grossem Detail beschrieben werden. Beispiele für Zusammensetzungen dieser Art sind Epoxydharzmassen, bei Zimmertemperatur aushärtbare Siliconharze, Polyester und Polytetrafluoräthylen. Ein bestimmter Typ des Einkapselungsmaterials ist eine Epoxydharzzusammensetzung, die unter dem Handelsnamen «Scotchcast» erhältlich ist. Eine geeignete Zusammensetzung enthält etwa 45,7 Gew.% eines Epoxydharzes, beispielsweise ein 2.2–Bis(4–hydroxyphenyl)propan–Epichlorhydrin–Addukt, cis–1,2–Cyclohexandicarbonsäureanhydrid und einen Pigmentfarbstoff wie eine Hysol–Farbstoffdispersion (Warenname der Dexter Corp.) Die Einkapselungszusammensetzung wird je nach ihrem chemischen Aufbau bei Zimmertemperatur oder Temperaturen bis zu 125°C während einer halben bis sechs Stunden ausgehärtet.

Nachdem die Einkapselungszusammensetzung ausgehärtet ist, werden die Stifte gewaschen, um jeglichen Rückstand von ihnen und auch die Beschichtung mit oben definierter Zusammensetzung zu entfernen. Die Rückstände und die Beschichtungszusammensetzung werden durch einfaches Waschen mit einem geeigneten Lösungsmittel wie Wasser oder einem niedrigen Alkohol wie Methanol, Äthanol oder Butanol, oder einem Keton wie Aceton entfernt. Bevorzugt wird Wasser als Waschflüssigkeit verwendet.

Die Stifte können in einer Tauchlötung oder mit einer Lötwelle gelötet werden. Bei dem Verfahren dieser Art werden die Stifte mit einem Lot, beispielsweise mit Zinn–Blei 63–37, eutektisches Gemisch) in einem Bad bei etwa 580°C während einiger Sskunden bedeckt. Wenn ein Lötverfahren angewendet wird, werden die Stifte noch einmal mit einem konventionellen Lötflussmittel oder mit der Zusammensetzung der vorliegenden Erfindung beschichtet. In diesem Fall wirkt die Zusammensetzung gemäss der Erfindung als Flussmittel und verhindert und entfernt Oxyde von den Stiften während der Einwirkung der Lötwelle. Das Lot verdrängt in diesem Fall während der Behandlung die Zusammensetzung, weil es den Überzug zum Schmelzen bringt.

Die Einkapselungszusammensetzung kann nachgehärtet werden, beispielsweise durch Erhitzen auf 150°C für etwa eine halbe bis zwei Stunden.

Beispiel 1

Eine erste Mischung von etwa 14 Gewichtsteilen eines festen Polyäthylenglykols (Carbowax 1500 Warenzeichen der Union Carbide Corp.), etwa 40 Gewichtsteilen Propylalkohol und etwa 0,5 Gewichtsteilen Diallylphthalat wird mit einer zweiten Mischung mit einem Gehalt an 13 Gewichtsteilen Maleinsäureanhydrid, etwa 32 Gewichtsteilen Aceton und etwa 0,4 Gewichtsteilen Polyvinylpyrrolidon vereinigt.

Ein Schwamm wird dann mit dieser Zusammensetzung getränkt. Die Stifte eines Moduls mit integrierten Schaltkreisen werden in den Schwamm eingeführt bis zu dem freizuhaltenden Bereich, um diese einheitlich mit der zuvor angegebenen Zusammensetzung zu bedecken. Anschliessend wird der Modul von dem Schwamm entfernt und umgedreht, so dass die Stifte nach oben schauen. Eine Epoxydharz-Zusammensetzung wird auf den Modul aufgetragen, so dass sie die Unterlage und einen Teil der Stifte in Höhe des vorher definierten freizuhaltenden Bereichs bedeckt. Die Epoxydharzzusammenstellung enthält etwa 45,7 Gew.%

2.2–Bis(4–hydroxyphenyl) propan–Epichlorhydrin–Epoxid, etwa 52,5 Gew.% cis–1,2–Cyclohexandicarbonsäureanhydrid und etwa 1,8 Gew.% der Hysol–Farbdispersion. Das Epoxidharz wird gehärtet durch ein 20 Minuten dauerndes Erhitzen auf etwa 120°C. Anschliessend werden die Stifte mit Wasser gewaschen, um jeglichen Rückstand von der Aushärtung des Epoxidharzes und dem Überzug der oben angegebenen Zusammensetzung zu entfernen. Die Stifte werden dann erneut durch Versprühen mit der oben angegebenen Zusammensetzung beschichtet und danach etwa 3 Minuten lang in ein Lötbad eines Zinn–Blei 63–37 eutektischen Gemisches von etwa 580°C getaucht. Das Lot verdrängt die Zusammensetzung.

Anschliessend wird der Modul einer Endhärtung wähernd einer halben Stunde bei 150°C unterworfen. Eine visuelle Prüfung ergibt, dass die Stifte von jedem Rückstand frei sind.

Beispiel 2

Beispiel 1 wird wiederholt mit der Ausmahme, dass etwa 0,6 Gewichtsteile d–Campher anstelle von Diallylphthalat verwendet werden. Es werden ähnliche Ergebnisse wie in Beispiel 1 erhalten.

Beispiel 3

Beispeil 1 wird wiederholt mit der Ausnahme, dass etwa 0,6 Gewichtsteile Triäthanolamin anstelle von Diallylphthalat verwendet werden.

**Patentansprüche**

1. Filmbildende Zusammensetzung zum Beschichten von Kontaktstiften eines Moduls vor dessen Rückseitenversiegelung, dadurch gekennzeichnet, dass sie

A) ein organisches Grundmaterial aus der Gruppe von Polyalkylenglykol, Polyalkylenglykolmonoester, Polyalkylenglykolmonoäther und Mischungen derselben, oder Kolophonium und Schellack

B) ein Carbonsäureanhydrid einer Säure mit bis zu 18 C–Atomen, einen Aldehyd mit bis zu 18 C–Atomen, oder Mischungen derselben

C) eine kleine Menge eines filmbildenden, thermoplastischen Polymeren enthält, wobei die Bestandteile A) und B) ineinander löslich sind; Bestandteil C) mit Bestandteil A) mischbar ist, mit Bestandteil B) aber nicht reagieren darf.

2. Zusammensetzung nach Anspruch 1, dadurch gekennzeichnet, dass das Grundmaterial A) ein Polyäthylenglykol, Polyäthylenglykolmonoester oder –monäther mit einem Molekulargewicht von 200 bis 6000 ist.

3. Zusammensetzung nach Anspruch 1, dadurch gekennzeichnet, dass das synthetische thermoplastische Polymer ein Molekulargewicht von 35.000 bis 150.000 aufweist.

4. Zusammensetzung nach Anspruch 1, dadurch gekennzeichnet, dass Bestandteil B) Maleinsäureanhydrid ist.

5. Zusammensetzung nach den Ansprüchen 1 bis 4, dadurch gekennzeichnet, dass sie zusätzlich ein nichtreaktives Verdünnungsmittel aus der Gruppe von Alkoholen, Glykolmonoalkyläthern, Ketonen oder Mischungen derselben und 0,2–1 Gew.–% eines Weichmachers aus der Gruppe von Phthalat mit 14 bis 38 C–Atomen, Campher oder Triäthanolamin enthält.

6. Zusammensetzung nach den Ansprüchen 1 und 5, dadurch gekennzeichnet,dass sie

A) 5 bis 30 Gewichtsprozent Grundmaterial,

B) 10 bis 30 Gewichtsprozent Carbonsäureanhydrid, Aldehyd, oder Mischungen derselben,

C) 0,2 bis 1 Gewichtsprozent filmbildendes thermoplastisches Polymer und zusätzlich mindestens 50 Gewichtsprozent nichtreaktiven Verdünner und 0,2 bis 1 Gewichtsprozent Weichmacher, bezogen auf das Gesamtgewicht der Zusammensetzung, enthält.

7. Zusammensetzung nach einem oder mehreren der Ansprüche 1 bis 6, dadurch gekennzeichnet, dass sie zusätzlich bis zu 5 Gewichtsprozent einer Polycarbonsäure oder einer Mono– oder Polycarbonsäure mit einer Hydroxylgruppe enthält.

8. Zusammensetzung nach den Ansprüchen 1 bis 7, dadurch gekennzeichnet, dass sie wasserlöslich ist.

## Claims

1. Film–forming composition for coating pins of a module prior to its backsealing, characterized in that it contains

A) an organic base material selected from the group consisting of polyalkylene glycol, polyalkylene glycol monoester, polyalkylene glycol monoether and mixtures thereof, or rosin and shellac

B) a carboxylic acid anhydride with up to 18 C–atoms, and aldehyde with up to 18 C–atoms, or mixtures thereof

C) a small quantity of a film–forming thermoplastic polymer, the components A) and B) being soluble with respect to each other; component C) being miscible with component A) but non–reactive with component B).

2. Composition as claimed in claim 1, characterized in that the base material A) is a polyethylene glycol, polyethylene glycol monoester or monoether with a molecular weight of 200 to 6000.

3. Composition as claimed in claim 1, characterized in that the synthetic thermoplastic polymer has a molecular weight between 35.000 and 150.000.

4. Composition as claimed in claim 1, characterized in that component B) is a maleic anhydride.

5. Composition as claimed in any one of claims 1 to 4, characterized in that it additionally contains a non–reactive diluent selected from the group consisting of alcohols, glycolmonoalkyl ethers, ketones, or mixtures thereof, and 0.2 to 1% by weight of a plasticizer selected from the group consisting of phthalate with 14 to 38 C–atoms, camphor or triethanolamine.

6. Composition as claimed in any one of claims 1 and 5, characterized in that it contains

A) 5 to 30% by weight base material,

B) 10 to 30% by weight carboxylic acid anhydride, aldehyde or mixtures thereof,

C) 0.2 to 1% by weight film–forming thermoplastic polymer

and additionally at least 50% by weight non–reactive diluent and 0.2 to 1% by weight plasticizer referring to the total weight of the composition.

7. Composition as claimed in one or several of claims 1 to 6, characterized in that it additionally contains up to 5% by weight of a polycarboxylic acid or of a mono– or polycarboxylic acid with a hydroxyl group.

8. Compositions as claimed in any one of claims 1 to 7, characterized in that it is water–soluble.

## Revendications

1. Composition filmogène pour le revêtement de broches de contact d'un module avant le scellement de la face arrière de celui–ci, caractérisée par le fait qu'elle contient:

A) une masse organique du groupe comprenant du glycol polyalkylénique, du monoester de glycol polyalkylénique, du monoéther de glycol polyalkylénique et des mélanges de ces derniers ou de la colophane et de la gomme–laque

B) un anhydride carboxylique d'un acide comportant jusqu'à 18 atomes C, un aldéhyde comportant jusqu'à 18 atomes C ou des mélanges de ces derniers,

C) une petite quantité d'un polymère thermoplastique filmogène, les composants A) et B) étant solubles les uns dans les autres; le composant C) pouvant être mélangé avec le composant A) mais ne devant pas réagir avec un composant B).

2. Composition selon la revendication 1, caractérisée par le fait que la masse A) est un polyéthylène–glycol, un monoester ou un monoéther de polyéthylène–glycol avec un poids moléculaire de 200 à 6000.

3. Composition selon la revendication 1, caractérisée par le fait que le polymère thermoplastique synthétique présente un poids moléculaire de 35.000 à 150.000.

4. Composition selon la revendication 1, caractérisée par le fait composant B) est un anhydride maléique.

5. Composition selon l'une quelconque des revendications 1 à 4, caractérisée par le fait qu'elle contient, en plus, un argent de dilution inerte du groupe d'alcools, de monoéthers alkyliques de glycol, de cétones ou de mélanges de ces derniers et de 0,2 à 1% en poids d'un plastifiant du group des phtalates avec 14 à 38 atomes C, du camphre ou de la triéthanolamine.

6. Composition selon l'une quelconque des revendications 1 et 5, caractérisée par le fait qu'elle contient:

A) 5 à 30 pour cent en poids de masse,

B) 10 à 30 pour cent en poids d'anhydride carboxylique d'aldhéyde ou des mélanges de ces derniers,

C) 0,2 à 1 pour cent en poids de polymère thermoplastique filmogène et

en plus, au moins 50 pour cent en poids d'argent de dilution inerte et 0,2 à 1 pour cent en poids de plastifiant, entrant dans le poids total de la composition.

7. Composition selon l'une quelconque ou plusieurs des revendications 1 à 6, caractérisée par le fait qu'elle contient, en plus, jusqu'à 5 pour cent en poids d'un polyacide carboxylique ou d'un mono ou polyacide carboxylique combiné à un hydroxyle.

8. Composition selon l'une quelconque des revendications 1 à 7, caractérisée par le fait qu'elle est hydrosoluble.